# EUROPÄISCHE PATENTSCHRIFT

(11) **EP 3 191 422 B1**
(45) Veröffentlichungstag und Bekanntmachung des Hinweises auf die Patenterteilung: **20.06.2018**
(21) Anmeldenummer: 15801995.0
(22) Anmeldetag: 01.09.2015
(51) Int. Cl.: C03C 17/00, C09D 183/04

(54) **VERFAHREN ZUR HERSTELLUNG STRUKTURIERTER BESCHICHTUNGEN**
METHOD FOR PRODUCING STRUCTURED COATINGS
PROCÉDÉ DE FABRICATION DE REVÊTEMENTS STRUCTURÉS

(30) Priorität: 12.09.2014 DE 102014218300
(43) Veröffentlichungstag der Anmeldung: 19.07.2017
(73) Patentinhaber: Evonik Degussa GmbH, 45128 Essen (DE)
(72) Erfinder: ANSELMANN, Ralf, 59348 Lüdinghausen (DE); BRINKMÖLLER, Christian, 48249 Dülmen (DE); HOPPE, Arne, 45136 Essen (DE); MERKULOV, Sonja, 45772 Marl (DE); RENNER, Gerhard, 64589 Stockstadt am Rhein (DE)
(86) Internationale Anmeldenummer: PCT/EP2015/069884
(87) Internationale Veröffentlichungsnummer: WO 2016/037887

(56) Entgegenhaltungen:
- WO-A1-97/06896
- DE-A1-102012 109 808

## Beschreibung

Die Erfindung betrifft ein Verfahren zur Herstellung strukturierter Beschichtungen. Insbesondere betrifft die Erfindung ein Verfahren zur Herstellung optisch dichter, temperaturstabiler, nichtleitender, strukturierter Beschichtungen. Ebenso betrifft die vorliegende Erfindung die mit dem erfindungsgemäßen Verfahren herstellbaren strukturierten Beschichtungen.

Strukturierte Beschichtungen sind von Bedeutung für viele technische Anwendungsfelder. Optisch dichte, nichtleitende strukturierte Beschichtungen sind essentiell für viele Anwendungen in der Halbleitertechnologie. Insbesondere für die Erzeugung von Displays werden optisch dichte, nichtleitende Beschichtungen benötigt, um den Rahmen des Displays einzufassen, elektronische Bauteile vor Licht zu schützen und/oder zur Pixelseparation der Farbfilter zu dienen. Die die vorgenannten Aufgaben erfüllende Beschichtung wird - da sie oft zu schwarzen Beschichtungen führen - als Schwarzmatrix (Black Matrix) bezeichnet. Sie können jedoch im Prinzip jede beliebige Farbe aufweisen. Bevorzugt sind Schwarzmatrizen jedoch schwarz oder weiß.

Im Stand der Technik sind verschiedene Verfahren zur Herstellung strukturierter Beschichtungen, insbesondere zur Herstellung von Schwarzmatrizen bekannt.

EP 0 762 996 A1 offenbart ein Verfahren zur Herstellung strukturierter Beschichtungen, bei dem die Strukturierung durch Prägewerkzeuge erzeugt wird. Für feine strukturierte Beschichtungen, wie sie z.B. in der Halbleitertechnik benötigt werden, ist dies Verfahren jedoch nicht anwendbar.

Schwarzmatrizen können auch z.B. durch Abscheidung von Chrom, insbesondere über Sputtering, hergestellt werden (EP 0 740 183 A1). Diese Methode hat jedoch den Nachteil, dass entsprechende Verfahren apparativ sehr aufwändig sind, große Aufbauten erfordern und die Integration in Prozesse zur Herstellung von Displays sehr aufwändig ist. Nachteilig an der Verwendung von Chrom ist weiterhin, dass es ein Schwermetall und somit umweltschädlich und sehr teuer in der Entsorgung ist.

Strukturierte Beschichtungen bzw. Schwarzmatrices können auch prinzipiell über Einfärben mit einem organischen Farbstoff hergestellt werden (EP 0 740 183 A1). Zur Erzielung von strukturierten Beschichtungen mit einer hohen Farbtiefe und einer gleichmäßigen Farbverteilung sind Beschichtungszusammensetzungen enthaltend einen organischen Farbstoff jedoch nicht geeignet. Insbesondere schwarze Beschichtungen können mit diesen Lösungen nicht hergestellt werden, da es bislang keine organischen Farbstoffe gibt, die zu tiefschwarzen Beschichtungen führen. Auch Beschichtungszusammensetzungen enthaltend Gemische verschiedener Farbstoffe haben den Nachteil, zu einer nicht ausreichenden Farbtiefe zu führen. Weiterhin resultieren nachteilige inhomogenen Färbungen. Auch sind Beschichtungen enthaltend organische Farbstoffe nicht geeignet, Temperaturen, wie sie bei der Displayerzeugung oft eingesetzt werden, stand zu halten. Aus diesem Grund haben Lösungen enthaltend organische Farbstoffe bislang nicht zu einer kommerziellen Verwendung bei der Displayherstellung geführt.

Mit üblichen Druckverfahren, die Beschichtungszusammensetzungen einsetzen, die farbgebende Mittel umfassen, bei denen es sich nicht um organische Farbstoffe handelt, können weiterhin bislang auch keine ausreichend fein strukturierten Beschichtungen und insbesondere keine ausreichen scharf begrenzten Schwarzmatrices hergestellt werden. Eine Möglichkeit zur Erzeugung von Schwarzmatrices beruht zum Beispiel auf der Verwendung einer Beschichtungszusammensetzung umfassend ein Bindemittel und ein anorganisches Pigment (EP 0 740 183 A1). Als Pigment kann dabei Ruß (insbesondere 'Carbon Black', d. h. Pigmentruß) eingesetzt werden. Ruß ist jedoch nachteilig, da entsprechende Beschichtungen leitend werden können. Alternativ werden auch Metalloxide, insbesondere Spinell-Farbpigmente, eingesetzt. Von diesen sind Spinell-Farbpigmente besonders bevorzugt, da mit ihnen auch nicht leitende Beschichtungen aus Beschichtungszusammensetzungen enthaltend hohen Pigmentkonzentrationen hergestellt werden können. Weiterhin lassen sich Pigmentruße und viele andere Pigmente nur schlecht dispergieren oder neigen zum Koagulieren, was wiederum einen negativen Einfluss auf die Güte der Schwarzmatrixschicht hat. Schließlich sind Spinell-Pigmente sehr temperaturstabil und können - anders als Pigmentruße und Nicht-Spinell-Pigmente - ggf. auch erst in den gehärteten Beschichtungen gebildet werden (Silva et al., Journal of Magnetism and Magnetic Materials, 272-276 (2004) e 1851-e1853). Die Farbpigmente können auch oberflächenbehandelt sein (vgl. z. B. DE 40 14 928 C1 und US 6,136,083 A). Mit den bisher bekannten, Metalloxid-Pigmente einsetzenden Verfahren können jedoch noch nicht ausreichend feine strukturierte Beschichtungen hergestellt werden.

Schließlich können strukturierte Beschichtungen bzw. Schwarzmatrices auch durch selektive Konvertierung photosensitiver Beschichtungszusammensetzungen umfassend ein Schwarzpigment (wie z.B. Ruß) erzeugt werden. Auch dies Verfahren führt jedoch zu minderwertigen Beschichtungen, insbesondere aufgrund von unvollständiger Konvertierung bei hohen Pigmentgehalten. EP 0 740 183 A1 offenbart ein Verfahren zur Herstellung strukturierter Beschichtungen, bei dem eine Beschichtungszusammensetzung umfassend ein schwarzes Verbindungs-Oxid-Pigment, das mindestens zwei Metalloxide umfasst, ein anorganisches Bindemittel und ein fotoempfindliches Harz auf ein Substrat aufgebracht wird, die aufgebrachte Beschichtungszusammensetzung durch eine Fotomaske mit einer Quecksilberdampflampe bestrahlt, entwickelt, gewaschen und ggf. weiter nacherhitzt wird. Der Einsatz auf organischen Systemen basierender fotoempfindlicher Harze hat jedoch den Nachteil, dass auch die unter ihrer Verwendung hergestellten Schichten nicht den hohen Temperaturen ausgesetzt werden können, die vorteilhaft bei der Displayherstellung eingesetzt werden.

Es stellt sich somit vorliegend die Aufgabe, die Nachteile des Standes der Technik zu vermeiden. Insbesondere stellt sich vorliegend die Aufgabe, ein Verfahren zur Herstellung strukturierter Beschichtungen bereitzustellen, mit dem sehr feine strukturierte Beschichtungen erzielt werden können und das farbgebende Beschichtungszusammensetzungen ohne organische Farbstoffe, Bindemittel und fotoempfindliche Harze einsetzt.

Diese Aufgabe wird gelöst durch ein Verfahren zur Herstellung strukturierter Beschichtungen, bei dem eine Beschichtungszusammensetzung umfassend mindestens ein anorganisches Bindemittel, mindestens ein Oxid-Pigment, das nach Zugabe eines Gemisches bestehend aus 15 ml 1 M Oxalsäure und 15 ml 20 %iger wässriger Salzsäure bezogen auf 1 g Substanz bei Standardbedingungen (SATP: 25 °C, 1,013 bar) zu einem Temperaturanstieg von mindestens 4 °C führt, und mindestens ein Lösemittel auf ein Substrat aufgebracht wird, der resultierende Beschichtungszusammensetzungsfilm partiell mit einem Fotolack beschichtet wird und das mit der Beschichtungszusammensetzung und dem Fotolack beschichtete Substrat mit einer Säure behandelt wird.

Das erfindungsgemäße Verfahren zur Herstellung strukturierter Beschichtungen eignet sich prinzipiell zur Herstellung beliebiger strukturierter Beschichtungen. Bevorzugt handelt es sich jedoch bei den damit herstellbaren Beschichtungen um strukturierte Beschichtungen aus dem Bereich der Halbleitertechnik. Besonders bevorzugt ist das erfindungsgemäße Verfahren ein Verfahren zur Herstellung strukturierter Schwarzmatrices. Überraschenderweise wurde dabei festgestellt, dass damit extrem feiner Strukturen (mit Breiten von < 10 µm) hergestellt werden können. Weiterhin weist das erfindungsgemäße Verfahren den Vorteil auf, dass es bereits mit relativ schwachen Säuren betrieben werden kann. Der Einsatz giftiger Ätzmittel wie z.B. Flusssäure kann somit vermieden werden.

Bei dem erfindungsgemäßen Verfahren wird eine Beschichtungszusammensetzung auf ein Substrat aufgebracht. Prinzipiell eignet sich jedes beliebige Substrat für das erfindungsgemäße Verfahren. Bevorzugt zum nachfolgenden Einsatz in der Halbleitertechnik sind jedoch Substrate ausgewählt aus Glas, Silicium, Siliciumdioxid, einem Metall- oder Übergangsmetalloxid, einem Metall oder einem polymeren Material, insbesondere PI, PEN, PEEK, PC oder PET. Das Substrat kann weiterhin unbehandelt oder behandelt sein. Der Begriff "behandeltes Substrat" schließt weiterhin nicht nur erfolgte Behandlungen zur Erzeugung gewünschter Oberflächeneigenschaften, sondern auch erfolgte Behandlungen zur Erzeugung gewünschter technischer Eigenschaften (insbesondere zur Erzeugung gewünschter elektronischer Eigenschaften, wie. z.B. Behandlungen zum Aufbringen von Displaystrukturen wie z.B. Pixeln) mit ein.

Die Beschichtungszusammensetzung, die auf das Substrat aufgebracht wird, umfasst mindestens ein anorganisches Bindemittel, mindestens ein Oxid-Pigment, und mindestens ein Lösemittel. Sie kann folglich noch weitere Zusammensetzungsbestandteile aufweisen. Bevorzugt besteht die erfindungsgemäße Beschichtungszusammensetzung jedoch ausschließlich aus einem oder mehreren Bindemitteln, einem oder mehreren Oxid-Pigmenten und einem oder mehreren Lösemitteln. Um besonders gut für Hochtemperaturanwendungen geeignete strukturierte Beschichtungen zu erzeugen, setzt das erfindungsgemäße Verfahren ausschließlich aus einem oder mehreren anorganischen Bindemitteln, einem oder mehreren Oxid-Pigmenten und einem oder mehreren Lösemitteln bestehende Beschichtungszusammensetzungen ein.

Bei der Beschichtungszusammensetzung handelt es sich bevorzugt um eine bei Standardbedingungen (SATP: 25 °C, 1,013 bar) flüssige Beschichtungszusammensetzung, die den Vorteil hat, besonders einfach aufgetragen werden zu können und zu besonders feinen Strukturen zu führen.

Die eingesetzte Beschichtungszusammensetzung umfasst mindestens ein anorganisches Bindemittel. Bevorzugt handelt es sich bei dem mindestens einen anorganischen Bindemittel um ein Bindemittel, das formell ein Kondensationsprodukt von ggf. alkylierten Alkoxysilanen ist.

Bevorzugte anorganische Bindemittel weisen die generische Formel SiₐR¹_{b}O_{c}(OR²)_{d} mit a ≥ 2, b ≥ 0, c ≥ 1, d ≥ 5 und R¹ und R² = organischem Rest auf.

Entsprechende anorganische Bindemittel - formal Oxyalkoxysilanverbindungen oder alkylierte Oxyalkoxysilanverbindungen - sind Kondensationsprodukte von Alkoxysilanen und ggf. alkylierten Alkoxysilanen und lassen sich aus diesen säure- oder säureesterkatalysiert herstellen. Als Edukte können bevorzugt Alkoxysilane der generischen Formel Si(OR²)₄ mit R² = organischem Rest und alkylierte Alkoxysilane der generischen Formel SiR¹(OR²)₃ mit R¹ und R² = organischem Rest eingesetzt werden. Die entsprechende Umsetzung lässt sich besonders gut in Wasser durchführen. Besonders gut lässt sich die Umsetzung mit Phosphorsäureestern, besonders bevorzugt mit Phosphorsäuremonomethylestern durchführen. Als Edukte können bevorzugt Alkoxysilane der generischen Formel Si(OR²)₄ und alkylierte Alkoxysilane SiR¹(OR²)₃ mit R¹ bzw. R² = -CH₃, -CH₂CH₃, -CH₂CH₂CH₃, -CH(CH₃)₂ eingesetzt werden. Obwohl die Reaktion in Gegenwart von Wasser durchgeführt wird, ist in der Regel nach Abschluss der Reaktion, d.h. nach Bildung des Bindemittels, Wasser nur in sehr geringen Anteilen von typischerweise < 5 Gew,-%, insbesondere < 2 Gew.-%, weiter insbesondere < 1 Gew.-% bezogen auf die Gesamtmasse der Beschichtungszusammensetzung vorhanden.

Weiter bevorzugte anorganische Bindemittel weisen somit die generische Formel SiₐR¹_{b}O_{c}(OR²)_{d} mit R¹ und R² = -CH₃, -CH₂CH₃, -CH₂CH₂CH₃, -CH(CH₃)₂, bevorzugt R¹ und R² = -CH₃ und/oder -CH₂CH₃, a ≥ 2, b ≥ 0, c ≥ 1 und d ≥ 5 auf.

Besonders gute Beschichtungen, die eine besonders geringe Sprödigkeit ausweisen, können bei Einsatz eines Gemisches von SiCH₃(OCH₂CH₃)₃ und Si(OCH₂CH₃)₄ erzielt werden. Die resultierenden Bindemittel weisen entsprechend die Reste R¹ = -CH₃ und R² = -CH₂CH₃ auf.

Besonders gut geeignet zur Herstellung fein strukturierbarer Schwarzmatrices, die besonders homogene Schichten mit niedrigen Oberflächenrauhigkeiten aufweisen sind weiterhin Beschichtungszusammensetzungen, die entsprechende Bindemittel mit a = 5 bis 150, bevorzugt a = 20 bis 100, bevorzugt a = 30 bis 80 Si-Atomen aufweisen.

Der Maximalwert für die Summe aus b + d liegt, insbesondere bei kleinen Werten für a, nahe bei 4·a. Der Wert für c beträgt mindestens 1 und steht mit den Werten a, b und d in der Beziehung 4·a = b + 2·c + d. Bevorzugt beträgt das Verhältnis von c zu a zur Erzielung besonders guter Eigenschaften der resultierenden Schicht im Mittel 1,1 bis 2,0, weiter bevorzugt 1,15 bis 1,8, ganz besonders bevorzugt 1,2 bis 1,5.

Bevorzugt sind die erfindungsgemäßen Beschichtungszusammensetzungen weiterhin im Wesentlichen frei von organischen Bindemitteln (d. h. der Anteil an organischem Bindemittel, bezogen auf die Gesamtmasse an Bindemittel, beträgt weniger oder gleich 5 Gew.-%, bevorzugt weniger oder gleich 2 Gew.-%, weiter bevorzugt 0 Gew.-%), da sie dann den großen Vorteil aufweisen, für Temperschritte mit bis zu 800 °C einsetzbar zu sein.

Das anorganische Bindemittel wird bei dem erfindungsgemäßen Verfahren weiter zur Erzielung besonders guter Ergebnisse in der Beschichtungszusammensetzung bevorzugt in Anteilen von 5 bis 75 Gew.-%, weiter bevorzugt 10 bis 45 Gew.-%, bezogen auf die Gesamtmasse der Beschichtung, eingesetzt.

Die bei dem erfindungsgemäßen Verfahren eingesetzte Beschichtungszusammensetzung weist weiterhin mindestens ein Oxid-Pigment auf, das nach Zugabe eines Gemisches bestehend aus 15 ml 1 M Oxalsäure und 15 ml 20 %iger wässriger Salzsäure (HCl) bezogen auf 1 g Substanz bei Standardbedingungen (SATP: 25 °C, 1,013 bar) zu einer Temperaturerhöhung von mindestens 4 °C führt.

Diese exotherme Reaktion nach der Zugabe des 30 ml umfassenden Gemisches aus 15 ml 1 M Oxalsäure und 15 ml 20 %iger wässriger Salzsäure (HCl) zu 1 g Oxid-Pigment, die sich für die erfindungsgemäß einsetzbaren Oxid-Pigmente im Gegensatz zu anderen Oxid-Pigmenten durch eine insbesondere 60 Sekunden nach der bei SATP erfolgten Zugabe und nachfolgendem Rühren bei 200 rpm erhöhte Temperatur von mindestens 29 °C zeigt, ist ein Hinweis auf eine Reaktivität und somit eine entsprechende Eignung des jeweiligen Mischoxid-Pigmentes.

Entsprechende Oxid-Pigmente können dabei als i) Pigmente auf Basis eines Oxides einer Oxidationsstufe eines (Halb)Metalls, ii) Pigmente auf Basis gemischter Oxide eines (Halb)Metalls in mehr als einer Oxidationsstufe (gemischtvalente Oxide eines (Halb)Metalls, z.B. Eisenoxid Fe₃O₄) und iii) Pigmente auf Basis gemischter Oxide (Mischphasenoxidpigmente) von mindestens zwei (Halb)Metallen in jeweils einer oder mehreren Oxidationsstufen verstanden werden. Der Begriff der (Halb)Metalle umfasst dabei gleichermaßen Metalle und Halbmetalle.

Bevorzugt handelt es sich bei dem mindestens einen Oxid-Pigment um ein Pigment auf Basis eines gemischten Oxids eines (Halb)Metalls in mehr als einer Oxidationsstufe (z.B. Eisenoxid Fe₃O₄) und/oder um ein Pigment auf Basis gemischter Oxide (d.h. um ein Mischphasenoxidpigment) von mindestens zwei (Halb)Metallen in jeweils einer oder mehreren Oxidationsstufen. Weiter bevorzugt handelt es sich bei dem Pigment um ein Pigment auf Basis gemischter Oxide von mindestens zwei (Halb)Metallen, die wiederum jeweils in einer oder in mehreren Oxidationsstufen vorliegen können. Ganz besonders bevorzugt handelt es sich bei dem Pigment um ein Pigment auf Basis gemischter Oxide von mindestens zwei Metallen, von denen mindestens zwei Metalle in unterschiedlichen Oxidationsstufen vorliegen (gemischtvalente Oxide). Entsprechende Verbindungen sind Oxide und/oder Mischoxide, und können z.B. eine Spinell-Struktur oder eine inverse Spinell-Struktur aufweisen (und somit einphasige Mischphasenpigmente sein), oder aber auch als Gemisch unterschiedlicher Kristallphasen vorliegen.

Besonders gute Ergebnisse werden erzielt mit Pigmenten, bei denen es sich um Eisen-Mangan-Mischoxide handelt. Weiter besonders bevorzugt sind Kupferoxid-haltige Eisen-Mangan-Mischoxide, mit denen ganz besonders gute Ergebnisse erzielt werden können. Unter entsprechenden "Mischoxid"-Pigmenten sind dabei sowohl einphasige als auch mehrphasige Mischkristall-Oxide zu verstehen.

Ganz besonders bevorzugte Kupferoxid-haltige Eisen-Mangan-Mischoxide sind solche, die über eine Calcinierung von Mangan(II)oxid (MnO), Mangan(III)oxid (Mn₂O₃), Eisen(II)oxid (FeO), Eisen(III)oxid (Fe₂O₃) und Kupfer(II)oxid (CuO) erhältlich sind. Entsprechende Mischoxide werden auch vom Colour Index (kurz C.I.) als "Pigment Black 26" bezeichnet. C.I. ist ein seit 1925 existierendes Nachschlagewerk aller gebräuchlichen Farbmittel und Farbstoffbasis-Chemikalien und gilt als Standardwerk auf dem Gebiet der Pigment- und Farbstoffchemie. Herausgegeben wird der Colour Index von der British Society of Dyers and Colourists und der American Association of Textile Chemists and Colorists.

Entsprechende besonders bevorzugte Pigmente sind unter der Bezeichnung Black 444 von The Shepherd Color Company, USA, Daipyroxide Black 9550 von Dainichiseika Color & Chemicals Mfg. Co., Ltd., Japan, Spinellschwarz 47400 von Kremer Pigmente GmbH und Co. KG, Deutschland und PS 24-3060 PK von Ferro GmbH, Deutschland erhältlich. Auch wenn diese besonders bevorzugten Pigmente als Mangan-Eisenschwarz-Spinelle bezeichnet werden, ist nicht gesichert, dass diese Pigmente überhaupt oder ausschließlich eine Spinellstruktur aufweisen.

In Ergänzung zu den genannten Oxid-Pigmenten können in der Zusammensetzung auch weitere Farbpigmente, insbesondere Titandioxid, Zinkweiß, Spinellblau, Lithopone, Bariumsulfat, Zinkoxid, Calciumcarbonat, Cristobalit oder Kaolin vorhanden sein. Bevorzugt enthalten die erfindungsgemäßen Zusammensetzungen jedoch nur die zuvor beschriebenen Oxid-Pigmente, die zu der beschriebenen Temperaturerhöhung führen.

Weiterhin ist die Zusammensetzung zur Erzielung besonders gut nichtleitender Beschichtungen bevorzugt kohlenstofffrei, d.h. sie enthält keine Anteile von Kohlenstoffmodifikationen wie Ruß, Graphit, Aktivkohle, Kohlenstaub, Fullerenen, Graphen und dergleichen. Unter "aufweisend keine Anteile von Kohlenstoffmodifikationen" ist dabei ein Anteil an Kohlenstoffmodifikationen von maximal 0,5 Gew.-%, bevorzugt von maximal 0,2 Gew.-%, ganz besonders bevorzugt von maximal 0,1 Gew.-% bezogen auf die Gesamtmasse an eingewogener Pigmentmasse zu verstehen.

Der Anteil an Oxid-Pigmenten mit der beschriebenen Eigenschaft in der Zusammensetzung beträgt bevorzugt bezogen auf die Gesamtmasse der Zusammensetzung 10 bis 50, weiter bevorzugt 15 bis 40, besonders bevorzugt 15 bis 35 Gew.-%.

Die Zusammensetzung weist weiterhin mindestens ein Lösemittel auf. Prinzipiell sind sowohl organische Lösemittel als auch Wasser als Lösemittel denkbar. Besonders gute Beschichtungen resultieren jedoch, wenn das mindestens eine Lösemittel ein organisches Lösemittel oder ein Gemisch organischer Lösemittel ist. Bevorzugt handelt es sich bei dem organischen Lösemittel um einen Alkohol, einen Alkylester, einen Alkoxyalkohol und/oder einen Alkoxyalkylester. Ganz besonders bevorzugt handelt es sich bei dem mindestens einen Lösemittel um 1-Methoxy-2-propanol, Ethyllactat, Butylacetat, Ethylbenzoat, Propylenglykol-monomethylethylacetat,Tri(ethylenglycol)monoethylether (Ethyltriglycol, TGEE), Ethanol, Isopropanol und/oder Butanol.

Generell beträgt der Anteil des bzw. der Lösemittel bevorzugt 20 - 80, weiter bevorzugt 35 - 70 Gew.-% bezogen auf die Gesamtmasse der Beschichtung.

Die Zusammensetzung kann weiterhin neben den essentiellen Bestandteilen anorganisches Bindemittel, Lösemittel und Oxid-Pigment auch noch weitere Zusätze und Additive aufweisen. So kann die Zusammensetzung neben dem mindestens einen Oxid-Pigment weitere Pigmente oder Farbstoffe aufweisen. Bevorzugt weist die erfindungsgemäße Zusammensetzung als Pigmentbestandteile jedoch nur Oxid-Pigmente auf. Weiterhin kann die Zusammensetzung als Additiv zur Erzielung positiver Eigenschaften mindestens ein Netz-, Dispergier- und/oder Verlaufsadditiv aufweisen. Besonders bevorzugte Additive sind Additive auf Basis von Urethancopolymeren oder z.B. mit Siloxanen modifizierten Polyethern. Besonders bevorzugte Additive sind die im Handel erhältlichen Produkte mit der Bezeichnung TEGO Dispers 656 und TEGO Glide 450 (jeweils der Fa. Evonik Goldschmidt GmbH) und BYK 111 (der Byk Chemie GmbH). Weiterhin kann der erfindungsgemäßen Beschichtungszusammensetzung auch zur Erzielung vorteilhafter Eigenschaften partikuläres SiOₓ als Füllstoff zugesetzt sein.

Bevorzugt weist die bei dem erfindungsgemäßen Verfahren eingesetzte Zusammensetzung zur Erzielung einer besonders guten Beschicht-, Verdruck- bzw. Versprühbarkeit eine Viskosität von 1 mPa·s bis 10 Pa·s, insbesondere 1 mPa·s bis 100 mPa·s bestimmt nach DIN 53019 Teil 1 bis 2 und gemessen bei 20 °C auf. Entsprechende Viskositäten können durch Zugabe von Polymeren, Cellulosederivaten, oder z.B. unter der Handelsbezeichnung Aerosil erhältlichem SiO₂, und insbesondere bevorzugt durch PMMA, Polyvinylalkohol, Urethanverdicker oder Polyacrylatverdicker eingestellt werden.

Zusätze und Additive werden, so sie überhaupt vorhanden sind, üblicherweise in Anteilen von maximal 10, bevorzugt maximal 3 Gew.-% bezogen auf die Gesamtmasse der Zusammensetzung eingesetzt.

Die eingesetzten Beschichtungszusammensetzungen lassen sich, insbesondere bei Wahl einer oder mehrerer der beschriebenen bevorzugten Ausführungsformen für anorganisches Bindemittel, Oxid-Pigment und Lösemittel, sehr gut strukturieren. Weiterhin haben die beschriebenen Beschichtungszusammensetzungen den Vorteil, dass sie sich bereits mit schwachen Säuren bzw. schwachen Säuregemischen erfolgreich sehr fein strukturieren lassen und somit eine Ätzung über z.B. hochtechnische Vakuum-Prozesse (wie z.B. beim Trockenätzen) oder mit starken bzw. stark gesundheits- bzw. umweltschädlichen Säuren (wie Flusssäure) nicht erforderlich ist.

Die beschriebenen Beschichtungszusammensetzungen führen bei der Verwendung in dem erfindungsgemäßen Verfahren neben den gewünschten Vorteilen überraschenderweise weiterhin auch zu einer besonders hohen optischen Dichte der resultierenden Beschichtung.

Das Aufbringen der Beschichtungszusammensetzung auf das Substrat kann sowohl flächig als auch strukturiert erfolgen. Besonders einfach und somit vorteilhaft kann das Verfahren durchgeführt werden, wenn das Aufbringen der Beschichtungszusammensetzung flächig erfolgt.

Die erfindungsgemäße Beschichtungszusammensetzung kann im Prinzip in beliebiger Art und Weise auf das Substrat aufgebracht werden.

Bevorzugt wird die Beschichtungszusammensetzung mit einem Beschichtungsverfahren ausgewählt aus Druckverfahren (insbesondere Flexo/Gravur-Druck, Inkjet-Druck - ganz besonders bevorzugt kontinuierlicher, thermischer oder Piezo-Inkjet-Druck -, Offset-Druck, digitalem Offset-Druck und Siebdruck), Sprühverfahren, Rotationsbeschichtungsverfahren ("Spin-coating"), Tauchverfahren ("Dip-coating") und Verfahren ausgewählt aus Meniscus Coating, Slit Coating, Slot-Die Coating, und Curtain Coating auf das Substrat aufgebracht. Ganz besonders bevorzugt wird die Beschichtungszusammensetzung über ein Druckverfahren oder Rotationsbeschichtungsverfahren aufgebracht. Als Druckverfahren eignet sich insbesondere InkJet sowie Flüssigtonerverfahren (wie z. B. HP Indigo), da diese Verfahren sich besonders gut für eine strukturierte Auftragung des Druckmaterials eignet. Ganz besonders bevorzugt ist das erfindungsgemäße Verfahren ein Rotationsbeschichtungsverfahren, da so besonders einfach eine flächige Beschichtung erzielt werden kann.

Wird die flüssige Beschichtungszusammensetzung per Rotationsbeschichtung aufgebracht, erfolgt dies bevorzugt bei Geschwindigkeiten zwischen 100 und 5000 rpm. Bevorzugt wird zunächst erst bei einer niedrigen Rotationsgeschwindigkeit von 100 bis 1000 rpm über eine Zeitdauer von 5 s bis 30 s beschichtet und anschließend noch einmal für einen Zeitraum von 10 s bis 120 s die Rotationsgeschwindigkeit auf 1500 bis 5000 rpm erhöht.

Prinzipiell kann bei Wahl geeigneter Parameter direkt nach dem Aufbringen der Beschichtungszusammensetzung der Fotolack aufgetragen werden.

Bevorzugt wird nach dem Aufbringen der flüssigen Beschichtungszusammensetzung jedoch zunächst vor dem Aufbringen des Fotolacks das Lösemittel durch Trocknung entfernt. Weiterhin verhindert dies ein Reißen der Schicht bei dem späteren Härtungsschritt und verbessert die Adhäsion der Beschichtungszusammensetzung auf dem Substrat. Die Trocknung erfolgt bevorzugt thermisch bei Normaldruck bei Temperaturen zwischen 50 und 150 °C innerhalb von Trocknungszeiten zwischen 30 s und einer Stunde. Weiter bevorzugt erfolgt die Trocknung über ein Erhitzen auf 90 - 120 °C (bei 1013 mbar) über einen Zeitraum von 5 - 10 Minuten. Der entsprechende optionale Trocknungsschritt kann auch als "Pre-Annealing" bezeichnet werden.

Im Anschluss an das Aufbringen der Beschichtungszusammensetzung bzw. die daran anschließende Trocknung wird der resultierende Film partiell mit einem Fotolack beschichtet. Dabei kann die Beschichtung sowohl flächig aufgetragen und im Anschluss selektiv strukturiert werden (z.B. über einen Maskenprozess und nachfolgenden Abtrag der nicht gewünschten Bereiche) oder durch einen strukturierten Auftrag des Fotolacks (z.B. über einen Druckprozess). Mittel und Wege dafür sind dem Fachmann, genauso wie die Eignung der jeweiligen im Handel erhältlichen Fotolacke, dabei bekannt. Ein besonders bevorzugtes Handelsprodukt ist der Fotolack AZ 1514H von MicroChemicals GmbH.

Nach dem partiellen Auftrag des Fotolacks resultiert ein beschichtetes Substrat, das einen flächig oder strukturiert aufgetragenen Beschichtungsfilm zeigt, der wiederum partiell von einer strukturierten Fotolackschicht bedeckt ist. Die Bereiche des mit strukturiertem Fotolack bedeckten Beschichtungsfilmes entsprechen dabei der gewünschten pigmentierten Beschichtung, z.B. der Schwarzmatrix.

Im Anschluss an den partiellen Auftrag des Fotolacks wird das mit der Beschichtungszusammensetzung und dem Fotolack beschichtete Substrat mit einer Säure behandelt. Überraschenderweise hat sich gezeigt, dass so die den genannten Temperaturanstieg zeigenden Pigmente aus den nicht mit Fotolack bedeckten Beschichtungszusammensetzungsfilmen herausgelöst werden können. Durch die Behandlung mit Säure wird die zuvor aufgetragene Beschichtung somit transparent.

Unter einer Säure im Sinne der vorliegenden Erfindung ist dabei eine anorganische Säure oder eine organische Carbonsäure zu verstehen. Dabei handelt es sich um chemische Verbindungen, die Protonen (H⁺-Ionen) bilden und in wässriger Lösung einen pH-Wert kleiner 7,00 aufweisen. Bevorzugt einsetzbare Säuren weisen einen pH-Wert zwischen 1 und 6, weiter bevorzugt zwischen 1 und 3 auf. Bevorzugt einsetzbare Säuren sind Salzsäure, Schwefelsäure, Phosphorsäure, Salpetersäure, Flusssäure, Kieselsäure, Kohlensäure, Essigsäure, Zitronensäure und Benzoesäure. Bevorzugt einsetzbare Säuren sind wässrige Oxalsäure in einer Konzentration von 0,3 bis 2,5 mol/l und wässrige Salzsäure von 3,0 -12,0 mol/l (letztere entsprechend 10 - 35 Gew.-%). Eingesetzt werden können auch Gemische der vorgenannten Säuren. Ganz besonders gute Ergebnisse erzielen Gemische im Verhältnis von 1:2 bis 2:1 (Volumenanteile) von 1 M wässriger Oxalsäure und 6 M wässriger HCl.

Die Behandlung mit Säure kann in beliebiger Weise erfolgen. Bevorzugt wird das beschichtete Substrat in ein entsprechendes Tauchbecken eingetaucht. Bevorzugte Behandlungsdauern bzw. Eintauchzeiten betragen dabei 1 bis 15, weiter bevorzugt 3 bis 5 Minuten. Die Behandlung mit Säure erfolgt weiterhin bevorzugt bei Standardbedingungen (SATP: 25 °C, 1,013 bar).

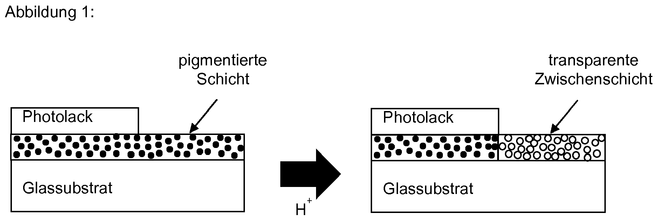

Die Säurebehandlung führt zu einem Herauslösen der genannten Oxid-Pigmente aus der Beschichtung (vgl. Abbildung 1). Dabei verbleibt die in Säure nicht lösliche Beschichtung auf Basis des anorganischen Bindemittels an Ort und Stelle. Ihre leicht poröse Oberfläche eignet sich bevorzugt für den Auftrag von Folgebeschichtungen, insbesondere von Antireflex- oder Anti-Fingerprint-Beschichtungen.

Zur Erzielung entsprechender bevorzugter beschichteter Substrate, die noch eine farblose anorganische Beschichtung aufweisen, wird somit im Anschluss an die Säurebehandlung der Fotolack entfernt und die zurückgebliebene Beschichtung ausgehärtet. Bevorzugt kann der Fotolack durch Lösen in organischen Lösemitteln entfernt werden. Besonders bevorzugt kann der Fotolack mit Lösemitteln wie z.B. Aceton entfernt werden.

Besonders glatte und somit ebenfalls bevorzugte Schichten resultieren jedoch, wenn die nach der Säurebehandlung von Pigment befreite Beschichtung partiell oder vollständig, bevorzugt vollständig, entfernt wird. Die pigmentfreie anorganische Beschichtung kann dabei bevorzugt mit Basen entfernt werden.

Bei einer Base im Sinne der vorliegenden Erfindung handelt es sich um chemische Verbindungen, die Hydroxidionen (OH⁻-Ionen) bilden und in wässriger Lösung einen pH-Wert größer 7,00 aufweisen. Bevorzugt einsetzbare Basen weisen einen pH-Wert zwischen 8 und 14, weiter bevorzugt zwischen 11 und 14 auf. Eine bevorzugt einsetzbare Base ist dabei wässrige NaOH in Konzentrationen von 0,02 bis 1,0 M.

Die Behandlung mit Base kann in beliebiger Weise erfolgen. Bevorzugt wird das beschichtete Substrat in ein entsprechendes Tauchbecken eingetaucht. Bevorzugte Behandlungsdauern bzw. Eintauchzeiten betragen dabei 10 Sekunden bis 5 Minuten, weiter bevorzugt 10 bis 90 Sekunden. Die Behandlung mit Base erfolgt weiterhin bevorzugt bei Standardbedingungen.

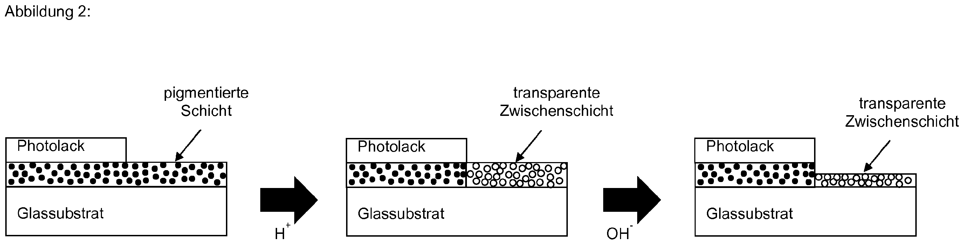

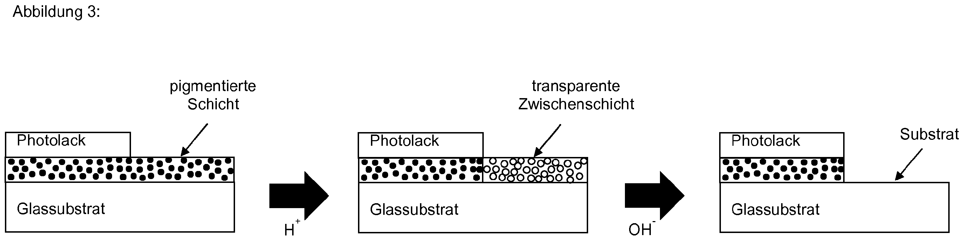

In einer ebenfalls bevorzugten Ausführungsform der vorliegenden Erfindung wird im Anschluss an die Säurebehandlung die pigmentfreie Beschichtung partiell (vgl. Abbildung 2) oder vollständig (Abbildung 3) entfernt, dann der Fotolack entfernt und schließlich die zurückgebliebene Beschichtung ausgehärtet. Besonders glatte und somit besonders bevorzugte Beschichtungen resultieren, wenn die pigmentfreie Beschichtung vollständig entfernt wird.

Die nachfolgende Härtung erfolgt, unabhängig davon, ob die pigmentfreie Beschichtung partiell bzw. vollständig entfernt wird oder nicht, bevorzugt bei einem Druck von 1013 mbar über eine Zeit von 1 Minuten bis 1 Stunde bei Temperaturen von 200 °C bis 800 °C, bevorzugt über eine Zeit von 1 - 10 Minuten bei Temperaturen von 300 - 400 °C.

Gegenstand der vorliegenden Erfindung sind weiterhin die nach dem erfindungsgemäßen Verfahren herstellbaren strukturierten Schichten.

Gegenstand der vorliegenden Erfindung ist weiterhin die Verwendung der nach dem erfindungsgemäßen Verfahren herstellbaren Schichten in elektronischen Bauteilen und im Automobilbau.

### Beispiele:

### Beispiel 1: Ansetzen der Sol-Gel Matrix

- Vermengt werden TEOS (15,44 wt. %) und MTES (66,18 wt. %).
- Nachfolgend hinzugegeben werden VE-H20 (9,18 wt. %) und Phosphorsäureester Hordaphos CCMS (0,02 wt. %).
- Das Gemisch wird über Nacht auf der Rührplatte gerührt.
- Anschließend wird nochmals VE-H2O (9,18 wt. %) hinzugegeben.
- Der Sol-Gel Ansatz reift für 2 Tage (unter Rühren).

### Beispiel 2: Herstellung der Dispersion

- Vorgelegt wird das Lösemittel 1-Methoxy-2-Propanol (57,85 wt. %), um den Sol-Gel Ansatz auf die geeignete Feststoffkonzentration zu verdünnen.
- Anschließend werden 15,03 wt. % des Sol-Gel Ansatzes beigemengt.
- Das Netz- und Dispergieradditiv TEGO Dispers 710 (2,10 wt. %) wird hinzugefügt.
- Als letztes wird das Spinellschwarz "tiefstschwarz (Fe,Mn)(Fe,Mn)₂O₄" der Fa. Kremer Pigmente GmbH & Co. KG hinzugegeben (Menge 25,02 wt. %).
- Für die Dispergierung mittels Schüttelmischer (Scandex) werden ca. 30 g Zirkonoxid Mahlperlen der Größe 0,4 bis 0,6 mm beigemengt.
- Der Dispersions Ansatz wird für mindestens 2 Stunden, besser aber 10 Stunden, im Schüttelmischer dispergiert.
- Nach der Dispergierung werden die Mahlperlen durch Sedimentation oder Filterung entfernt.

### Beispiel 3: Substratbeschichtung

- Als zu beschichtenden Substrate werden Glassubstrate verwendet.
- Die Glassubstrate werden vor dem Beschichten mit organischem Lösemittel (Isopropanol) gereinigt, mit Di-Wasser abgespült und anschließend mit Stickstoff trocken gepustet.
- Die Dispersion wird mittels Rotationsbeschichtungsverfahren (Spincoating) aufgetragen mit folgenden Parametern: 10 sec bei 500 rpm, anschließend 30 sec bei 2000 rpm.
- Vor der Strukturierung erfolgt ein Prebake Schritt, um das Lösemittel langsam zu entfernen und ein Reißen der Schicht zu vermeiden (10 Min bei 100 °C auf der Hot Plate).

### Beispiel 4: Auftragung des Photolackes; UV-Belichtung

- Auf die beschichteten Glassubstrate wird mittels Rotationsbeschichtungsverfahren (Spincoating) der Fotolack AZ 1514H der Firma MicroChemicals GmbH aufgetragen mit folgenden Parametern: 30 sec bei 2000 rpm.
- Die Aushärtung findet bei 80 Sekunden bei 180°C °C auf der Hot Plate statt.
- Nach dem Aushärten werden die Substrate für 10 Sekunden mit UV-Licht durch eine Maske im Mask Aligner belichtet.

### Beispiel 5: Entwicklung

- Die belichteten Glassubstrate werden für 2,5 Minuten in ein Bad mit AZ Developer von der Firma MicroChem GmbH entwickelt.
- Danach werden die Glassubstrate mit Di-Wasser gespült und mit Stickstoff trocken gepustet.

### Beispiel 6: Strukturierung

- Die Glassubstrate werden in einem ersten Schritt für 5 Minuten in einem Bad bestehend aus 1 M Oxalsäure und 20 %iger wässriger Salzsäure 1:1 behandelt.
- Danach werden die Glassubstrate mit Di-Wasser gespült und mit Stickstoff trocken gepustet.
- Die Glassubstrate werden in einem zweiten Schritt für 40 Sekunden in einem Bad bestehend aus 0,5 M Natronlauge behandelt.
- Danach werden die Glassubstrate mit Di-Wasser gespült und mit Stickstoff trocken gepustet.

### Beispiel 7: Aushärtung

- Die Aushärtung findet bei 5 Minuten bei 350 °C auf der Hot Plate statt.

## Patentansprüche

1. Verfahren zur Herstellung strukturierter Beschichtungen, bei dem
a. eine Beschichtungszusammensetzung umfassend
i. mindestens ein anorganisches Bindemittel,
ii. mindestens ein Oxid-Pigment, das nach Zugabe eines Gemisches bestehend aus 15 ml 1 M Oxalsäure und 15 ml 20 %iger wässriger Salzsäure bezogen auf 1 g Substanz bei Standardbedingungen zu einem Temperaturanstieg von mindestens 4 °C führt, und
iii. mindestens ein Lösemittel
auf ein Substrat aufgebracht wird,
b. der resultierende Beschichtungszusammensetzungsfilm partiell mit einem Fotolack beschichtet wird und
c. das mit der Beschichtungszusammensetzung und dem Fotolack beschichtete Substrat mit einer Säure behandelt wird.

2. Verfahren nach Anspruch 1, **dadurch gekennzeichnet, dass** das anorganische Bindemittel die generischen Formel SiₐR¹_{b}O_{c}(OR²)_{d} mit a ≥ 2, b ≥ 0, c ≥ 1, d ≥ 5 und R¹ und R² = organischem Rest aufweist.

3. Verfahren nach Anspruch 1 oder 2,
**dadurch gekennzeichnet, dass**
das Pigment ein Pigment auf Basis eines gemischten Oxids eines (Halb)Metalls in mehr als einer Oxidationsstufe und/oder ein Pigment auf Basis mindestens zweier gemischter Oxide von mindestens zwei (Halb)Metallen in jeweils einer oder mehreren Oxidationsstufen ist.

4. Verfahren nach Anspruch 3,
**dadurch gekennzeichnet,**
**dass** es ein Eisen-Mangan-Mischoxid ist.

5. Verfahren nach Anspruch 4,
**dadurch gekennzeichnet,**
**dass** es ein Kupferoxid-haltiges Eisen-Mangan-Mischoxid ist.

6. Verfahren nach Anspruch 5,
**dadurch gekennzeichnet,**
**dass** das Eisen-Mangan-Mischoxid die über eine Calcinierung von Mangan(II)oxid, Mangan(III)oxid, Eisen(II)oxid und Eisen(III)oxid und Kupfer(II)oxid erhältlich ist.

7. Verfahren nach Anspruch 6,
**dadurch gekennzeichnet,**
**dass** das Pigment der Gruppe der Pigmente mit der Colour-Index-Bezeichnung Pigment Black 26 zugeordnet wird.

8. Verfahren nach einem der vorhergehenden Ansprüche,
**dadurch gekennzeichnet, dass**
der Anteil an Oxid-Pigment bezogen auf die Gesamtmasse der der Zusammensetzung 10 - 50 Gew.-% beträgt.

9. Verfahren nach einem der vorhergehenden Ansprüche,
**dadurch gekennzeichnet, dass**
das mindestens eine Lösemittel ausgewählt aus einem Alkohol, einem Alkylester, einem Alkoxyalkohol und/oder einem Alkoxyalkylester ist.

10. Verfahren nach einem der vorhergehenden Ansprüche,
**dadurch gekennzeichnet, dass**
als Säure wässrige Oxalsäure in einer Konzentration von 0,3 bis 2,5 mol/l, wässrige Salzsäure 3,0 - 12,0 mol/l oder volumenanteilige Gemische im Verhältnis von 1:2 bis 2:1 von 1 M wässriger Oxalsäure und 6 M wässriger HCl eingesetzt werden.

11. Verfahren nach einem der vorhergehenden Ansprüche, **dadurch gekennzeichnet, dass** im Anschluss an die Säurebehandlung
a. der Fotolack entfernt wird und
b. die zurückgebliebene Beschichtung ausgehärtet wird.

12. Verfahren nach einem der Ansprüche 1 bis 10, **dadurch gekennzeichnet, dass** im Anschluss an die Säurebehandlung
a. die pigmentfreie Beschichtung partiell oder vollständig entfernt wird,
b. der Fotolack entfernt wird und
c. die zurückgebliebene Beschichtung ausgehärtet wird.

13. Strukturierte Beschichtung, erhältlich nach einem Verfahren nach einem der Ansprüche 1 bis 12.

14. Verwendung einer strukturierten Beschichtung nach Anspruch 13 in elektronischen Bauteilen oder im Automobilbau.

## Claims

1. Process for producing structured coatings, in which
a. a coating composition comprising
i. at least one inorganic binder,
ii. at least one oxide pigment which, after addition of a mixture consisting of 15 ml of 1 M oxalic acid and 15 ml of 20% aqueous hydrochloric acid based on 1 g of substance, under standard conditions, leads to a temperature rise of at least 4°C, and
iii. at least one solvent
is applied to a substrate,
b. the resulting coating composition film is partially coated with a photoresist and
c. the substrate coated with the coating composition and the photoresist is treated with an acid.

2. Process according to Claim 1, **characterized in that** the inorganic binder has the generic formula SiₐR¹_{b}O_{c}(OR²)_{d} with a ≥ 2, b ≥ 0, c ≥ 1, d ≥ 5 and R¹ and R² = organic radical.

3. Process according to Claim 1 or 2,
**characterized in that**
the pigment is a pigment based on a mixed oxide of a (semi)metal in more than one oxidation state and/or a pigment based on at least two mixed oxides of at least two (semi)metals each in one or more oxidation states.

4. Process according to Claim 3,
**characterized in that**
it is a mixed iron-manganese oxide.

5. Process according to Claim 4,
**characterized in that**
it is a copper-containing mixed iron-manganese oxide.

6. Process according to Claim 5,
**characterized in that**
the mixed iron-manganese oxide the is obtainable via a calcination of manganese(II) oxide, manganese(III) oxide, iron(II) oxide and iron(III) oxide and copper(II) oxide.

7. Process according to Claim 6,
**characterized in that**
the pigment is assigned to the group of pigments having the Colour Index designation Pigment Black 26.

8. Process according to any of the preceding claims,
**characterized in that**
the proportion of oxide pigment, based on the total mass of the of the composition, is 10%-50% by weight.

9. Process according to any of the preceding claims,
**characterized in that**
the at least one solvent is selected from an alcohol, an alkyl ester, an alkoxy alcohol and/or an alkoxyalkyl ester.

10. Process according to any of the preceding claims,
**characterized in that**
the acid used is aqueous oxalic acid in a concentration of 0.3 to 2.5 mol/l, aqueous hydrochloric acid 3.0-12.0 mol/l or mixtures having proportion by volume ratios of 1:2 to 2:1 of 1 M aqueous oxalic acid and 6 M aqueous HCl.

11. Process according to any of the preceding claims,
**characterized in that** after the acid treatment
a. the photoresist is removed and
b. the remaining coating is cured.

12. Process according to any of Claims 1 to 10,
**characterized in that** after the acid treatment
a. the pigment-free coating is removed partially or completely,
b. the photoresist is removed and
c. the remaining coating is cured.

13. Structured coating obtainable by a process according to any of Claims 1 to 12.

14. Use of a structured coating according to Claim 13 in electronic components or in automobile construction.

## Revendications

1. Procédé de fabrication de revêtements structurés, selon lequel
a. une composition de revêtement comprenant :
i. au moins un liant inorganique,
ii. au moins un pigment d'oxyde qui conduit après l'ajout d'un mélange constitué par 15 ml d'acide oxalique 1 M et 15 ml d'acide chlorhydrique aqueux à 20 % pour 1 g de substance dans des conditions standards à une élévation de température d'au moins 4 °C, et
iii. au moins un solvant,
est appliquée sur un substrat,
b. le film de composition de revêtement résultant est partiellement revêtu avec une photorésine, et
c. le substrat revêtu avec la composition de revêtement et la photorésine est traité avec un acide.

2. Procédé selon la revendication 1, **caractérisé en ce que** le liant inorganique présente la formule générique SiₐR¹_{b}O_{c}(OR²)_{d} avec a ≥ 2, b ≥ 0, c ≥ 1, d ≥ 5 et R¹ et R² = radical organique.

3. Procédé selon la revendication 1 ou 2, **caractérisé en ce que** le pigment est un pigment à base d'un oxyde mixte d'un (semi-)métal à plus d'un état d'oxydation et/ou un pigment à base d'au moins deux oxydes mixtes d'au moins deux (semi-)métaux chacun à un ou plusieurs états d'oxydation.

4. Procédé selon la revendication 3, **caractérisé en ce qu'**il s'agit d'un oxyde mixte de fer et de manganèse.

5. Procédé selon la revendication 4, **caractérisé en ce qu'**il s'agit d'un oxyde mixte de fer et de manganèse contenant de l'oxyde de cuivre.

6. Procédé selon la revendication 5, **caractérisé en ce que** l'oxyde mixte de fer et de manganèse la peut être obtenu par une calcination d'oxyde de manganèse (II), d'oxyde de manganèse (III), d'oxyde de fer (II) et d'oxyde de fer (III) et d'oxyde de cuivre (II).

7. Procédé selon la revendication 6, **caractérisé en ce que** le pigment correspond au groupe des pigments ayant la désignation Colour Index Pigment Black 26.

8. Procédé selon l'une quelconque des revendications précédentes, **caractérisé en ce que** la proportion de pigment d'oxyde par rapport à la masse totale de la de la composition est de 10 à 50 % en poids.

9. Procédé selon l'une quelconque des revendications précédentes, **caractérisé en ce que** ledit au moins un solvant est choisi parmi un alcool, un ester alkylique, un alcoxy-alcool et/ou un ester alcoxy-alkylique.

10. Procédé selon l'une quelconque des revendications précédentes, **caractérisé en ce que** de l'acide oxalique en une concentration de 0,3 à 2,5 mol/l, de l'acide chlorhydrique aqueux à 3,0 à 12,0 mol/l ou des mélanges volumiques en un rapport de 1:2 à 2:1 d'acide oxalique aqueux 1 M et d'HCl aqueux 6 M sont utilisés en tant qu'acide.

11. Procédé selon l'une quelconque des revendications précédentes, **caractérisé en ce qu'**après le traitement avec un acide,
a. la photorésine est éliminée et
b. le revêtement restant est durci.

12. Procédé selon l'une quelconque des revendications 1 à 10, **caractérisé en ce qu'**après le traitement avec un acide,
a. le revêtement sans pigment est éliminé en partie ou en totalité,
b. la photorésine est éliminée et
c. le revêtement restant est durci.

13. Revêtement structuré, pouvant être obtenu par un procédé selon l'une quelconque des revendications 1 à 12.

14. Utilisation d'un revêtement structuré selon la revendication 13 dans des composants électroniques ou dans la construction d'automobiles.
